Europäisches Patentamt

European Patent Office

Office européen des brevets

(19)

(11) Veröffentlichungsnummer: **0 268 969 B1**

(12) **EUROPÄISCHE PATENTSCHRIFT**

(45) Veröffentlichungstag der Patentschrift: **29.07.92**

(51) Int. Cl.5: **G01R 1/073**

(21) Anmeldenummer: **87116894.4**

(22) Anmeldetag: **16.11.87**

(54) **Adapter für ein Leiterplattenprüfgerät.**

(30) Priorität: **18.11.86 DE 3639359**
**29.10.87 DE 3736689**

(43) Veröffentlichungstag der Anmeldung:
**01.06.88 Patentblatt 88/22**

(45) Bekanntmachung des Hinweises auf die
Patenterteilung:
**29.07.92 Patentblatt 92/31**

(84) Benannte Vertragsstaaten:
**AT BE CH DE FR GB IT LI LU NL SE**

(56) Entgegenhaltungen:
**EP-A- 0 164 672**
**DE-A- 3 507 619**

**VA-KATALOG, Februar 1985, Ingun Prüfmittelbau, Konstanz;**

(73) Patentinhaber: **Luther, Erich**
**Hagenburger Strasse 26**
**W-3050 Wunstorf(DE)**

Patentinhaber: **Maelzer, Martin**
**Hagenburger Strasse 26**
**W-3050 Wunstorf(DE)**

(72) Erfinder: **Maelzer, Martin**
**Hagenburger Strasse 26**
**W-3050 Wunstorf(DE)**
Erfinder: **Dehmel, Rüdiger**
**Ringstrasse 22a**
**W-3050 Wunstorf(DE)**
Erfinder: **Higgen, Hans-Hermann**
**Am Bückeberg 7**
**W-3060 Stadthagen(DE)**
Erfinder: **Gülzow, Andreas**
**Am Schlage 30**
**W-3257 Springe 6(DE)**

(74) Vertreter: **Schmidt-Evers, Jürgen, Dipl.-Ing. et al**
**Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10**
**W-8000 München 22(DE)**

## Beschreibung

Die Erfindung bezieht sich auf einen Adapter mit Prüfstiften nach dem Oberbegriff des Anspruchs 1.

Es ist der Zweck eines solchen Adapters, mittels der Prüfstifte eine elektrische Verbindung zwischen im Raster befindlichen Prüfkontakten und in und/oder außer Raster befindlichen Prüfpunkten zu schaffen. Dies wird durch eine Positionierung der Prüfstifte im Adapter in bestimmten Schrägstellungen erreicht. Die Bestückung des Adapters mit den Prüfstiften kann sowohl manuell als auch maschinell und dabei halb- oder vollautomatisch erfolgen.

Ein Adapter mit Prüfstiften der eingangs bezeichneten Art ist aus DE-A-3 507 619 bekannt. Bei dieser Ausgestaltung weisen die Prüfstifte zylindrische Schäfte auf, deren den Köpfen der Prüfstifte abgewandte Stirnflächen zwecks Bildung von Kontaktabschnitten kegelförmig angespitzt sind, wobei der Spitzenwinkel etwa 90° beträgt.

Diese bekannte Ausgestaltung hat sich als sehr vorteilhaft erwiesen, jedoch ist sie aus folgenden Gründen noch verbesserungsbedürftig. Aufgrund der vorgegebenen Dicke der Prüfstifte können nur solche Prüflinge geprüft werden, deren Prüfpunkte einen verhältnismäßig großen Abstand voneinander haben. Hierdurch sind die Einsatzmöglichkeiten dieses Adapters beschränkt, und zwar auch für sog. SMD-Prüflinge (SMD = surface mounted devices).

Der Erfindung liegt die Aufgabe zugrunde, einen Adapter mit Prüfstiften der eingangs bezeichneten Art so auszugestalten, daß auch Prüflinge mit einem verhältnismäßig geringen Abstand ihrer Prüfpunkte voneinander bzw. mit großen Versetzungen außer Raster geprüft werden können.

Diese Aufgabe wird durch das Kennzeichen des neuen Anspruchs 1 gelöst.

Bei der erfindungsgemäßen Ausgestaltung können die Prüfstifte so weit schräggestellt werden, daß ihre Spitze jeweils dicht am benachbarten Prüfstift liegt. Anders ausgedrückt sind die Prüfstifte so angespitzt, daß ihre Spitzen bei maximal möglicher Schrägstellung der Prüfstifte - gesehen in einer Projektion senkrecht zu den Führungsplatten - Punkte bilden, die etwa auf dem Umfang ihres Projektionsbildes liegen. Bei der erfindungsgemäßen Ausgestaltung läßt sich der Abstand zwischen den Prüfpunkten ganz erheblich verringern. In diesem Zusammenhang ist zu bemerken, daß der Abstand der Prüfpunkte auch von der aus Festigkeitsgründen erforderlichen Wanddicke zwischen zwei benachbarten Führungslöchern des Adapters abhängig ist. Infolgedessen sind im Rahmen der Erfindung auch solche Ausgestaltungen möglich, bei denen die Spitze des Prüfstiftes sich in einem solchen Abstand innerhalb des Randes des Projektionsbildes befindet, der etwas geringer ist als die halbe Wandstärke zwischen den benachbarten Führungslöchern.

Ein sich gleichmäßig verjüngender Prüfstift ist deshalb vorteilhaft, weil sich die Versatzabmessungen der Führungslöcher in den Führungsplatten nach einfacheren Kriterien bemessen. Ein sich stufenförmig verjüngender Prüfstift ist aus herstellungstechnischen Gründen vorteilhaft, weil sich ein solcher Prüfstift durch Hämmern herstellen läßt.

Die Ausgestaltungen nach den Ansprüchen 2 bis 4 führen zu einem bezüglich unterschiedlicher maximaler Schrägstellungen in den meisten Fällen einsetzbaren und somit universalen Prüfstift.

Aufgrund des jeweiligen kegelförmigen Übergangs von Stufe zu Stufe gemäß Anspruch 4 ist eine störungsfreie Einführung der Prüfstifte in die Führungslöcher gewährleistet.

Die Ausgestaltung nach Anspruch 5 führt zu einer Vereinfachung des Adapters.

Gemäß Anspruch 6 wird das Einführen der Prüfstifte verbessert.

Die Ausbildung nach Anspruch 8 trägt dazu bei, die Prüfstifte im Bereich ihrer Spitze zu stabilisieren. Es kann sich bei dieser Maßnahme sowohl um eine progressive Verjüngung handeln als auch um eine kegelförmige Anspitzung mit einem gegenüber der übrigen Verjüngung größeren Kegelwinkel . Es ist auch vorteilhaft, die Spitze der Prüfstifte zu runden, was ebenfalls eine progressive Verjüngung darstellt.

Aufgrund der erfindungsgemäßen Querschnittsverringerung sind die Prüfstifte insbesondere im Bereich nahe ihrer Spitze biegsam. Eine gewisse Biegsamkeit ist einerseits vorteilhaft, jedoch soll andererseits zumindest eine wesentliche Verbiegung der Prüfstifte vermieden werden. Hierzu tragen die Merkmale der Ansprüche 9 bis 19 bei.

Die Ausbildungen nach den Ansprüchen 20 und 21 beziehen sich auf eine einfache und kostengünstig herstellbare Distanzierung bzw. Positionierung der Führungsplatten im zugehörigen Adapterrahmen.

Die Ausgestaltung gemäß Anspruch 23 ist deshalb vorteilhaft, weil sich größere Anlageflächen zwischen der Führungslochwandung und dem Prüfstift ergeben. Außerdem können die Führungslöcher gemeinsam gebohrt werden.

Nachfolgend wird die Erfindung anhand von in vereinfachten Zeichnungen dargestellten Ausführungsbeispielen näher erläutert. Es zeigt

Fig. 1    einen Teilschnitt durch ein Gerät zum Prüfen von Leiterplatten, wobei der Teilschnitt senkrecht zum im Gerät aufgenommenen, mit Prüfstiften bestückten Adapter verläuft;

Fig. 2    den Adapter im vertikalen Querschnitt;

Fig. 3      den Schnitt III-III in Fig. 2;

Fig. 4 bis 6      unterschiedliche Ausgestaltungen für Prüfstifte;

Fig. 7      eine Prüfstiftspitze in vergrößerter Darstellung;

Fig. 8      einen Prüfstift mit seinem Projektionsbild;

Fig. 9 und 10      unterschiedliche Positionen bzw. Schrägstellungen für Prüfstifte im Adapter;

Fig. 11 bis 14      Einzelheiten der Führung der Prüfstifte in vergrößerter Darstellung.

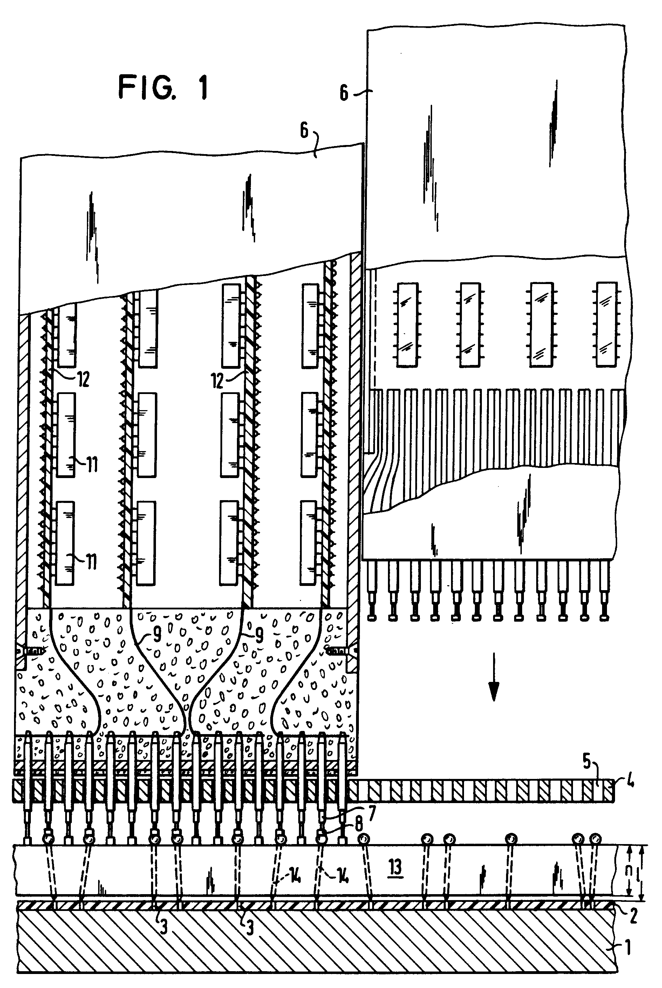

In der Fig. 1 ist eine Aufnahmeplatte des im ganzen nicht dargestellten Gerätes zum Prüfen von Leiterplatten mit 1 bezeichnet. Auf dieser Aufnahmeplatte 1 befindet sich eine Leiterplatte 2 mit Prüfpunkten 3. Oberhalb der zu prüfenden Leiterplatte 2 befinden sich eine Rasterlochplatte 4, deren Löcher 5 im Raster angeordnet sind, und zwei in Richtung auf die Leiterplatte 2 und zurück bewegliche Moduln 6, die an ihren unteren Stirnseiten mit Prüfkontakten 7 in Form von Stiften versehen sind, welche in der herabgefahrenen Position eines Moduls 6 die Löcher 5 in der Rasterlochplatte 4 durchgreifen. Die Prüfkontakte 7 tragen teleskopisch ein- und ausfahrbare Prüfkontaktköpfe 8, die in Richtung auf ihre äußere Endstellung durch eine nicht dargestellte Feder vorgespannt sind.

Die Prüfkontakte 7 sind in den Moduln 6 durch Vergießen befestigt und stehen durch elektrische Leitungen 9 mit IC-Chips 11 tragenden Leiterplatten 12 in Verbindung, die innerhalb der Moduln 6 angeornded sind und in ihrer Gesamtheit mit den Leiterplatten 12, den IC-Chips 11 und ggf. weiteren Bauelementen eine den Prüfkontakten 7 zugeordnete Teilschalter-Matrix bilden.

Auf der Leiterplatte 2 befindet sich ein Rasteranpassungs-Adapter 13, der eine Vielzahl ihn durchfassender Prüfstifte 14 aufweist, die die im Raster angeordneten Prüfkontakte 7 mit den in und/oder außer Raster angeordneten Prüfpunkten 3 verbinden. Betreffende Prüfstifte 14 liegen deshalb nicht in der jeweiligen Flucht mit den Prüfkontakten, sondern erstrecken sich schräg durch den Adapter 13, wobei sie an ihren oberen Enden mit Köpfen und an ihren unteren Enden mit Überlänge aus dem Adapter 13 hervorragen und gegenüber der Ober- und Unterseite erhabene Kontaktstellen bilden.

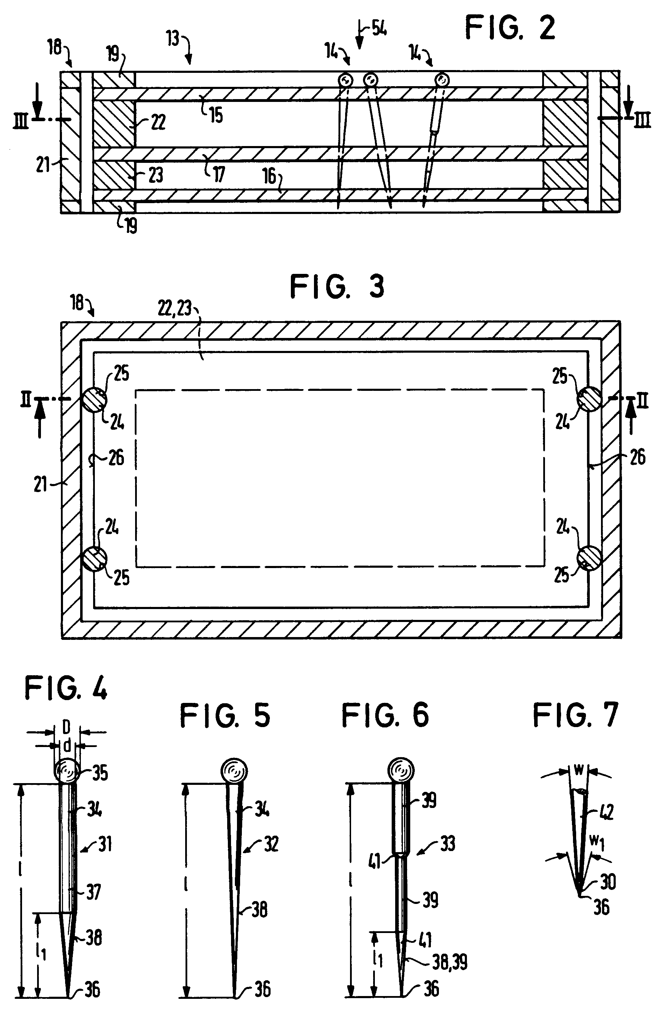

Der Adapter 13 weist mehrere übereinander angeordnete und einen Abstand zwischen sich aufweisenden Führungsplatten auf. Beim Ausführungsbeispiel gemäß Fig. 2 sind drei Führungsplatten vorhanden, von denen die oberste mit 15, die unterste mit 16 und die mittlere 17 bezeichnet ist. Es sind andeutungsweise drei Prüfstifte 14 dargestellt, die im einzelnen noch beschrieben werden. Der Adapter 13 weist einen allgemein mit 18 bezeichneten Rahmen auf, der aus Rahmenteilen 19, 21 bestehen kann, in dem die Führungsplatten 15 bis 17 mit zwischen diesen angeordneten Distanzleisten 22, 23 positioniert sind. Die Distanzleisten 22, 23 bilden jeweils ebenfalls einen Rahmen (vgl. Fig. 3) wodurch die Führungsplatten 15, 17 an ihrem ganzen Umfang abgestützt und somit erheblich stabilisiert sind.

Wie aus Fig. 3 deutlich zu erkennen ist, dienen zur horizontalen Positionierung der Führungsplatten 15 bis 17 im Rahmen 18 senkrecht angeordnete Haltebolzen 24 vorzugsweise runden Querschnitts, die auf verschiedene Weise im Rahmen 18, insbesondere in den oberen und unteren Rahmenteilen 19 fixiert sein können, z.B. in Löchern stecken, wobei Madenschrauben zur Axialfixierung dienen können. Es sind beim vorliegenden Ausführungsbeispiel vier Haltebolzen 24 vorgesehen, die aneinander gegenüberliegenden Seiten in einem Abstand voneinander angeordnet sind. Die Haltebolzen 24 greifen schließend in ihrem Querschnitt entsprechende etwa halbrunde Quernuten 25 ein, die sich an entsprechend gegenüberliegenden Rändern der Führungsplatten 15 bis 17 befinden. Diese Ausgestaltung ermöglicht bei einer sicheren Positionierung eine leichte Montage bzw. Demontage der Führungsplatten 15 bis 17, da diese nicht parallel eingeschoben werden müssen, sondern um einen der mit 26 bezeichneten Ränder ein- bzw. ausgeschwenkt werden können. Zwischen dem Rahmen 18 und dem Umfang der Führungsplatten 15 bis 17 bzw. deren Ränder 26 besteht ein Abstand, der ein Ergreifen der Führungsplatten ggf. mittels eines Werkzeugs ermöglicht. Eine vorteilhafte Herstellungsart der Quernuten 25 besteht darin, diese zunächst als Bohrungen in genau festgelegten Positionen in Führungsplatten 15 bis 17 größerer Abmessung einzubringen, z.B. durch Stanzen oder Bohren, und anschließend die betreffenden Ränder z.B. durch Fräsen soweit zu kürzen, daß sich etwa halbrunde Quernuten 25 ergeben.

Von den in den Fig. 4 bis 6 mit 31, 32 und 33 bezeichneten Prüfstiften besteht jeder aus einem im Querschnitt runden Schaft 34, der an einem Ende einen kugelförmigen Kopf 35 aufweist und an seinem anderen Ende angespitzt ist. Die Spitze ist jeweils mit 36 bezeichnet.

Der Schaft 34 des Prüfstiftes 31 gemäß Fig. 4 verläuft vom Kopf 35 her zunächst zylindrisch (Schaftabschnitt 37) und ist dann zu seiner Spitze 36 hin kegelförmig verjüngt. Die Verjüngung ist mit 38 bezeichnet und erstreckt sich über einen Teil der Schaftlänge 1 , dessen Länge $1_1$ sich ergibt, wenn man sich vorstellt, daß die Mantelfäche der Verjüngung innerhalb einer zylindrischen Einhüllenden liegen soll, die senkrecht zu den Führungsplatten steht.

Der Prüfstift 32 gemäß Fig. 5 ist auf seiner gesamten Schaftlänge 1 kegelförmig zur Spitze 36 hin verjüngt.

Der Prüfstift 33 gemäß Fig. 6 ist stufenförmig zur Spitze 36 hin verjüngt, wobei die mit 39 bezeichneten Stufen zylindrisch sind. Die Übergänge 41 von Stufe zu Stufe sind kegelförmig abgeschrägt. An die in Fig. 6 unterste Stufe 39 schließt sich eine kegelförmige Anspitzung 41 an, deren Länge $1_1$ sich ebenfalls ergibt, und die auch als weitere Stufe angesehen und funktionieren kann.

Zwecks Verstärkung der Spitze 36 ist es vorteilhaft, diese durch eine geringe Abstumpfung 30 zu bilden, was durch eine progressive Verjüngung, eine Rundung, eine geringe Abflachung oder auch durch eine kegelförmige Anspitzung eines gegenüber dem Winkel w der allgemein mit 42 bezeichneten Hauptverjüngung größeren Kegelwinkels $w_1$ gebildet sein kann. Eine so geformte Spitze 36 ist in Fig. 7 in vergrößerter Darstellung beispielhaft dargestellt.

Beim Ausführungsbeispiel gemäß Fig. 6 kann sich die Anzahl der Stufen 39 nach der Anzahl der vorhandenen Führungsplatten richten, d.h. zumindest im oberen Bereich des Adapters 13 kann jeder Führungsplatte eine Stufe zugeordnet sein.

Bei den vorliegenden Ausführungsbeispielen beträgt der größte Schaftdurchmesser d 1,3 bis 1,4 mm im Durchmesser, während der Durchmesser D des Kopfes 35 etwa 2 mm beträgt.

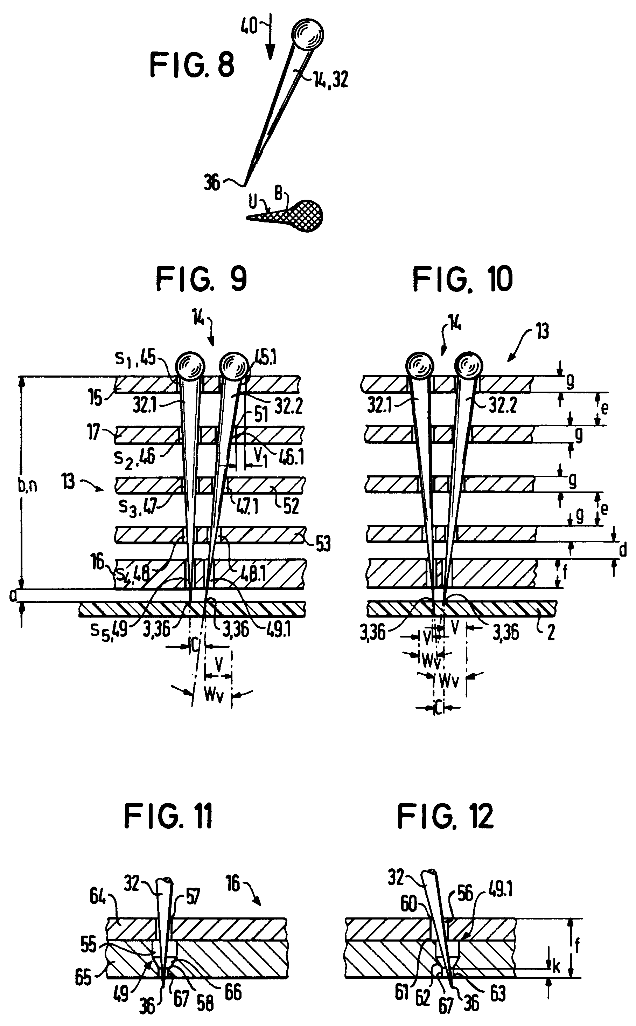

Fig. 8 zeigt einen Prüfstift 32 in max. Schrägstellung und in der Seitenansicht sowie sein Projektionsbild B in der Projektion von oben, d.h, senkrecht zu den Führungsplatten bzw. längs des Pfeiles 40. Es ist deutlich erkennbar, daß die Spitze sich im Projektionsbild B an dessen Umfang U befindet.

Die Prüfstift-Anordnungen gemäß den Fig. 9 und 10 stellen zwei prinzipielle maximale Schrägstellungen für Prüfstifte 14 dar, in denen diese die Prüfkontaktköpfe 8 mit den Prüfpunkten 3 der Leiterplatte 2 verbinden. Bei dem Beispiel gemäß Fig. 9, bei dem Prüfstifte 32 gemäß Fig. 5 verwendet werden, befinden sich der Prüfstift 32.1 bzw. die ihn aufnehmenden, zylindrischen Führungslöcher 45 bis 49 in einer zu den Führungsplatten senkrechten Position, d.h., es ist zwischen den Führungslöchern 45 bis 49 kein seitlicher Versatz vorhanden bzw. die Führungslöcher 45 bis 49 befinden sich im Raster. Dagegen befindet sich der mit 32.2 bezeichnete Prüfstift in einer maximalen Schrägstellung, in der seine Spitze 36 gegenüber dem zugehörigen Kopf 35 bzw. zugehörigen Führungsloch 45.1 um das Versatzmaß V zum Prüfstift 32.1 hin versetzt ist. Die Führungslöcher 46.1 bis 49.1 befinden sich somit außer Raster. Die zwischen den Führungslöchern 49 und 49.1 vorhandene Wandstärke bemißt sich zum einen nach einer erforderlichen Festigkeit und zum anderen nach dem Versatzwinkel $w_v$ sowie dem Abstand der Spitze 36 von der untersten Führungsplatte 16, der etwa 0,6 mm beträgt und den Kontaktionsabschnitt des Prüfstiftes darstellt. Der übrige Abschnitt b des Schaftes 34 des Prüfstiftes ist der Führungsabschnitt, auf dem der Prüfstift radial positioniert ist. Der Führungsabschnitt b entspricht der Höhe n des Adapters 13. Aufgrund der erfindungsgemäßen Ausgestaltung lassen sich Abstände c zwischen den Spitzen 36 erreichen, die etwa 0,6 mm betragen. Insbesondere für SMD-Prüflinge werden solche geringen Abstände c angestrebt.

Der Versatz $v_1$ zwischen dem Führungsloch 45.1 in der Führungsplatte 15 und dem Führungsloch 46.1 in der Führungsplatte 16 ist so groß bemessen, daß bei senkrechter Einführung des Prüfstiftes 32.2 dessen Spitze 36 in einer Position geringfügig innerhalb des Lochrandes 51 des Führungslochs 46.1 auf letzteres trifft, so daß der Führungsstift 32.2 zwangsläufig in das Führungsloch 46.1 eingezogen und dabei schräg gestellt wird. Die Führungslöcher 47.1 und 48.1 in den bei den Ausführungsbeispielen gemäß Fig. 9 und 10 vorhandenen zwei weiteren Führungsplatten 52, 53 zwischen der Führungsplatte 17 und der untersten Führungsplatte 16 können entsprechend versetzt sein, um beim Vorhandensein einer geringfügig gestumpften Spitze 36 (s. Fig. 7) oder beim Vorhandensein einer Verjüngung 38 gemäß Fig. 4 einen entsprechenden Einzugseffekt in die jeweilige Führungsbohrung zu erreichen. Beim Ausführungsbeispiel gemäß Fig. 5 ist jedoch grundsätzlich zu erklären, daß die ersten beiden Führungsplatten 15 und 17 eine sichere Führung in das unterste Führungsloch 49, 49.1 gewährleisten können, weil die Seitenlinie des Schaftes 34 sich gerade erstreckt. Die jeweils einer Führungsplatte 15 bis 17, 52, 53 zugehörigen Führungslöcher 45 bis 49, 45.1 bis 49.1 sind dabei im Durchmesser vorzugsweise jeweils gleich. Dagegen sind die Durchmesser der Führungslöcher den Führungsplatten 15 bis 17, 52, 53 von Führungsplatte zu Führungsplatte an den sich verjüngenden Prüfstiftquerschnitt anzupassen, abgesehen vom zylindrischen Bereich 37 des Prüfstifts 31. Die Durchmesser der Führungslöcher 45 bis 49 bzw. 45.1 bis 49.1 verringern sich somit zur Spitze 36 der Prüfstifte 14 hin.

Das Führungsspiel $s_1$ bis $s_5$ in den Führungslöchern nimmt in Einsteckrichtung 54 der Prüfstifte 32 ab. Zwecks genauer Führung ist für das unterste Führungsloch 49 bzw. 49.1 ein Spiel $s_5$ von nur 0,1 bis 0,2 mm vorgesehen.

Aufgrund der vorbeschriebenen Anordnung wird eine reproduzierbare Positionierung der Prüfstifte in den durch die Führungslöcher vorbestimmten Positionen in den Führungsplatten erreicht.

Den Führungsplatten 52, 53 kommt im wesentlichen eine seitliche Stützfunktion zu, da die Prüfstifte 14 bzw. 31, 33 in diesem Bereich aufgrund der Querschnitts-Verjüngung 38 recht dünn und deshalb biegsam sind. Die Stützfunktion wird insbesondere dann wirksam, wenn im Betrieb die Prüfstifte 14 zwecks Kontaktierung der Prüfpunkte 3 und der Prüfkontaktköpfe 8 axial unter Druck gesetzt werden. Für den gleichen Zweck ist der Abstand d zwischen der untersten Führungsplatte 16 und der darüber befindlichen Führungsplatte 53 geringer bemessen als der Abstand e zwischen den übrigen Führungsplatten, wobei die übrigen Abstände e vorzugsweise gleich sind.

Beim Ausführungsbeispiel gemäß Fig. 10 kommen ebenfalls Prüfstifte 32 zum Einsatz, wobei der Versatz V bzw. Versatzwinkel $w_v$ geringer ist als beim vorbeschriebenen Ausführungsbeispiel und zwar dadurch, daß beide Prüfstifte 32.1, 32.2 mit ihren Spitzen 36 um den gleichen Versatz V aufeinanderzu versetzt sind bzw. schräg stehen.

Aus den Fig. 9 und 10 ist deutlich erkennbar, daß aufgrund der erfindungsgemäßen Verjüngung der Prüfstifte 14 der Abstand c zwischen den Spitzen 36 zweier benachbarter Prüfstifte 14, von denen wenigstens einer schräg steht, erheblich verringert werden kann. Beim vorliegenden Ausführungsbeispiel beträgt der geringste Abstand c 0,6 mm. D.h., es können auch Prüflinge (Leiterplatten) mit einem geringen Abstand zwischen Prüfpunkten 3 geprüft werden.

Weitere Maßnahmen zur verbesserten seitlichen Abstützung der Prüfstifte 14 bzw. 31 bis 33 sind aus den Fig. 11 und 12 ersichtlich. Eine Maßnahme besteht darin, die unterste Führungsplatte 16 dicker (Maß f) zu bemessen, als die Dicke g der übrigen Führungsplatten 15, 17, 52, 53, die gleich dick bemessen sein können. Je größer die Dicke f ist, desto größer sind auch Stützabschnitte, die insbesondere dann wirksam ausgenutzt werden können, wenn die Führungslöcher 49, 49.1 an die Verjüngung 38 der Prüfstifte 14 angepaßt konisch verlaufen (nicht dargestellt) oder in Stufen angeordnet sind. Diese Stufen können erreicht werden, durch einerseits etwa mittige Locherweiterung 55 im Führungsloch 49, 49.1 und/oder wenigstens einen versetzten Lochabschnitt 56, wodurch bei entsprechender Anpassung der jeweiligen Lochdurchmesser an den jeweilig vorhandenen Querschnitt der Vejüngung 38 sich seitlich stützend wirksame Lochränder 57, 58 (Fig. 11) und 60 bis 63 (Fig. 12) ergeben. Zwecks leichterer Verwirklichung sowohl der Locherweiterung 55 als auch des versetzen Lochabschnitts 56 ist es vorteilhaft, die unterste Führungsplatte 16 aus zwei Plattenteilen 64, 65 zu bilden. Es ist auch noch hervorzuheben, daß der Abstand k der Locherweiterung 55 von der Unterseite der untersten Führungsplatte 16 gering, vorzugsweise etwa 1 mm, gehalten werden soll, um bei etwa senkrechter Anordnung des Prüfstiftes 14 einen möglichst nahe an der Spitze 36 gelegenen Abstützungspunkt (Lochrand 58) zu erhalten (Fig. 11). Die Locherweiterungen 55 gehen unterseitig mit konischen Abschnitten 66 in entsprechend kleinere Lochabschnitte 67 über.

Bei einer Schräganordnung des Prüfstiftes 14 (Fig. 12) findet die Spitze 36 ihre Abstützung schon am Lochrand 63 an der Unterseite der untersten Führungsplatte 16, die bei den Ausführungsbeispielen gemäß Fig. 11 und 12 etwa 3 mm dick ist. Der Abstand a der Spitze 36 von der untersten Führungsplatte 16 beträgt etwa 0,8 mm.

Sofern der Prüfstift 14 eine progressive Verjüngung 30 gemäß Fig. 7 aufweist, empfiehlt es sich, die Länge der progressiven Verjüngung 30 gleich oder kleiner zu bemessen als den Abstand k in Fig. 12, um bei einem Anheben der Leiterplatte 2 bei ihrer Prüfung eine gute Führung des Prüfstifts 14 zu gewährleisten.

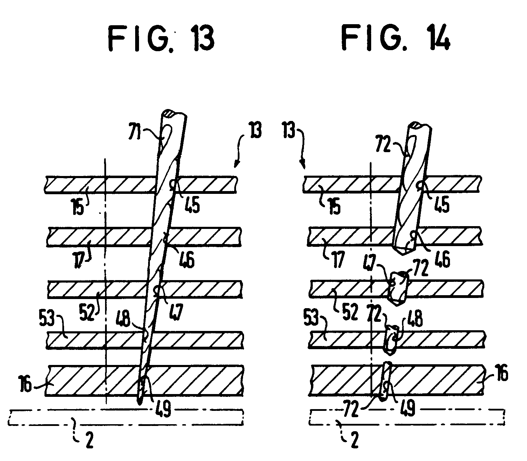

Im Rahmen der Erfindung ist es auch möglich, anstelle von zylindrischen Führungslöchern an die Form der Prüfstifte in der jeweiligen Stellung angepaßte, insbesondere konische und/oder stufenförmige Führungslöcher vorzusehen (vgl. Fig. 13 und 14). Bei den vorbeschriebenen Ausführungsbeispielen erstrecken sich die im Querschnitt runden Führungslöcher 45 bis 49 oder 45.1 bis 49.1 bzw. 55,56,57 senkrecht zu den Führungsplatten, wodurch ein separates Bohren der Führungslöcher bedingt ist. Die einzelnen Positionen der Führungslöcher können genau errechnet werden bzw. die Führungslöcher können in einer rechnergesteuerten Bohr- oder Stanzmaschine gebohrt bzw. gestanzt werden. Bei den Ausführungsbeispielen gemäß Fig. 13 und 14 können die hier ebenfalls mit 45 bis 49 bezeichneten Führungslöcher in der gewünschten Schräglage des Prüfstiftes 14,32 gebohrt werden und zwar einzeln mittels mehreren Bohrern entsprechender Dicke bzw. Konizität oder auch gemeinsam mit einem entsprechend lang bemessenen konischen und/oder gestuften bzw. einstückigen Bohrer 71,72. Die Bohrer 71,72 weisen unter Berücksichtigung eines gewissen Bewegungsspiels eine der gewünschten Form bzw. Abmessung des zugehörigen Prüfstiftabschnitts bzw. Prüfstiftes, vgl. z.B. Fig. 4 bis 6, entsprechende Formen bzw. Abmessungen auf, d.h., die Führungslöcher können in der gewünschten Schräglage konisch und/oder stufenförmig zylindrisch sein, wobei sie sich koaxial zum Prüfstift erstrecken.

**Patentansprüche**

1. Adapter mit Prüfstiften für ein Leiterplattenprüfgerät, mittels welchem im Raster befindliche Prüfkontakte (7) mit in und/oder außer Raster befindlichen Prüfpunkten (3) einer zu prüfenden Leiterplatte (2) durch in Führungslöchern (45-49; 45.1-49.1) des Adapters aufgenommene Prüfstifte (31, 32, 33) verbindbar sind, wobei die Prüfstifte (31, 32, 33) jeweils einen dem betreffenden Prüfpunkt (3) der Leiterplatte (2) zugewandten, spitz zulaufenden Kontaktionsabschnitt (a), der aus dem Adapter vorsteht, und einen sich daran anschließenden Führungsabschnitt (b), der im zugehörigen Führungsloch (45-49; 45.1-49.1) des Adapters geführt ist, aufweisen,

dadurch gekennzeichnet,

daß sich der Führungsabschnitt (b) gegen den Kontaktionsabschnitt (a) hin im Querschnitt konisch oder stufenförmig verringert, und daß der Querschnitt der Führungslöcher (45-49; 45.1-49.1) sich entsprechend verringert.

2. Adapter mit Prüfstiften nach Anspruch 1,
dadurch gekennzeichnet,
daß der Querschnitt der Prüfstifte (31 bis 33) sich über einen Teil des Führungsabschnitts (b) bzw. der Schaftlänge (1) zur Spitze (36) hin verringert.

3. Adapter mit Prüfstiften nach Anspruch 1,
dadurch gekennzeichnet,
daß der Querschnitt der Prüfstifte (31 bis 33) sich im wesentlichen über die gesamte Schaftlänge (1) zur Spitze (36) hin verringert.

4. Adapter mit Prüfstiften nach einem der Ansprüche 1 bis 3,
dadurch gekennzeichnet,
daß der Übergang von Stufe (39) zu Stufe (39) sich zur Spitze (36) hin konisch verjüngt.

5. Adapter mit Prüfstiften nach einem der Ansprüche 1 bis 4,
dadurch gekennzeichnet,
daß er eine erste (15), eine zweite (16) und eine zwischen beiden liegende dritte Führungsplatte (17) aufweist, die parallel zueinander angeordnet sind und die Führungslöcher für die Prüfstifte (14) aufweisen,
wobei die erste Führungsplatte (15) im Raster befindliche Führungslöcher (45,45.1) und die zweite Führungsplatte (16) in und/oder außer Raster befindliche Führungslöcher (49,49.1) aufweist.

6. Adapter mit Prüfstiften nach Anspruch 5,
dadurch gekennzeichnet,
daß die dritte Führungsplatte (17) oder auch weitere, zwischen der dritten (17) und der zweiten Führungsplatte (16) angeordnete Führungsplatten (52,53) ebenfalls in und/oder außer Raster befindliche Führungslöcher (46 bis 48 oder 46.1 bis 48.1) aufweisen, wobei die außer Raster befindlichen Führungslöcher (46.1 bis 48.1) der dritten oder auch der weiteren Führungsplatten (17,52,53) so gesetzt sind, daß die Prüfstifte (32.2) bei zunächst senkrechter Einführung in die Führungslöcher (45.1) der ersten Führungsplatte mit ihrem sich verjüngenden Ende auf jeden Fall noch in das nächste Führungsloch (46.1 bis 49.1) treffen und somit bei weiterem Einführen zwingend in die außer Raster befindlichen Führungslöcher (49.1) der zweiten Führungsplatte (16) gelenkt werden.

7. Adapter mit Prüfstiften nach einem der Ansprüche 1 bis 6,
dadurch gekennzeichnet,
daß die Anzahl der Stufen (39) der Anzahl der Führungsplatten (15 bis 17) oder der Anzahl der Führungsplatten weniger eins entspricht.

8. Adapter mit Prüfstiften nach einem der Ansprüche 1 bis 7,
dadurch gekennzeichnet,
daß der Querschnitt der Prüfstifte (31 bis 33) sich wenigstens nahe der Spitze (36) progressiv verjüngt (Fig. 7).

9. Adapter mit Prüfstiften nach einem der Ansprüche 1 bis 8,
dadurch gekennzeichnet,
daß zwischen der ersten und der zweiten Führungsplatte (15,16) wenigstens zwei weitere Führungsplatten, vorzugsweise drei weitere Führungsplatten (17,52,53), angeordnet sind.

10. Adapter mit Prüfstiften nach Anspruch 9,
dadurch gekennzeichnet,
daß der Abstand (d) zwischen der zweiten Führungsplatte (16) und der benachbarten Führungsplatte (53) kleiner ist als der Abstand (e) zwischen den übrigen Führungsplatten (15,17,52).

11. Adapter mit Prüfstiften nach einem der Ansprüche 1 bis 10,
dadurch gekennzeichnet,
daß das Spiel ($s_1$ bis $s_5$) der Führungslöcher (45 bis 49,45.1 bis 49.1) sich in Einsteckrichtung (54) verringert.

12. Adapter mit Prüfstiften nach einem der Ansprüche 1 bis 11,
dadurch gekennzeichnet,
daß das Spiel ($s_5$) in der zweiten Führungsplatte (16) etwa 0,1 bis 0,2 mm beträgt.

**13.** Adapter mit Prüfstiften nach einem der Ansprüche 1 bis 12,
dadurch gekennzeichnet,
daß die Spitze (36) der Prüfstifte (31 bis 33) etwa 0,3 bis 1,5 mm, vorzugsweise etwa 0,8 mm, aus der zweiten Führungsplatte (16) herausragt.

**14.** Adapter mit Prüfstiften nach einem der Ansprüche 1 bis 13,
dadurch gekennzeichnet,
daß die zweite Führungsplatte (16) dicker ist als die übrigen Führungsplatten (15,17,52,53).

**15.** Adapter mit Prüfstiften einem der Ansprüche 1 bis 14,
dadurch gekennzeichnet,
daß der Durchmesser der Prüfstifte (31 bis 33) im Bereich der zweiten Führungsplatte (16) etwa 0,4 mm beträgt.

**16.** Adapter mit Prüfstiften nach einem der Ansprüche 1 bis 15,
dadurch gekennzeichnet,
daß die Führungslöcher (49,49.1) wenigstens in der zweiten Führungsplatte (16) in Einsteckrichtung (54) konisch oder stufenförmig konvergieren.

**17.** Adapter mit Prüfstiften nach einem der Ansprüche 1 bis 16,
dadurch gekennzeichnet,
daß die zweite Führungsplatte (16) durch einen äußeren und einen inneren Plattenteil (65,64) gebildet ist.

**18.** Adapter mit Prüfstiften nach Anspruch 17,
dadurch gekennzeichnet,
daß der Führungslochabschnitt (56) im inneren Plattenteil (64) weniger weit versetzt ist als der Führungslochabschnitt (55,66,67) im äußeren Plattenteil (65).

**19.** Adapter mit Prüfstiften nach einem der Ansprüche 1 bis 18,
dadurch gekennzeichnet,
daß das Spiel ($s_1$ bis $s_5$) durch die Loch- bzw. Stufenränder (57,58,60,61,62,63) bestimmt ist.

**20.** Adapter mit Prüfstiften nach einem der Ansprüche 1 bis 19,
dadurch gekennzeichnet,
daß die Führungsplatten (15 bis 17,52,53) durch Distanzstücke, vorzugsweise einen Rahmen bildende Distanzleisten (22,23) voneinander beabstandet sind.

**21.** Adapter mit Prüfstiften nach einem der Ansprüche 1 bis 20,
dadurch gekennzeichnet,
daß die Führungsplatten (15 bis 17,52,53) mittels wenigstens zwei in einander gegenüberliegenden Rändern (26) eingelassenen Quernuten (25) und darin liegenden Haltebolzen (24) im Adapterrahmen (18) positioniert sind.

**22.** Adapter mit Prüfstiften nach einem der Ansprüche 1 bis 21,
dadurch gekennzeichnet,
daß die Führungslöcher (45 bis 49, 45.1 bis 49.1,-55,56,57) sich senkrecht zu den Führungsplatten (15 bis 17,52,53) erstrecken bzw. senkrecht zu den Führungsplatten eingearbeitet (gebohrt, gestanzt) sind.

**23.** Adapter mit Prüfstiften nach einem der Ansprüche 1 bis 21,
dadurch gekennzeichnet,
daß die Führungslöcher (45 bis 49, 45.1 bis 49.1,55,-56,57) sich in der gewünschten Schräglage des jeweils zugehörigen Prüfstiftes (14,32,32.1,32.2) in den Führungsplatten (15 bis 17,52,53) erstrecken bzw. in dieser Schräglage in den Führungsplatten eingearbeitet (gebohrt, gestanzt) sind.

**Claims**

**1.** An adapter with test pins for a printed circuit board testing device, by means of which test contacts (7) located on the grid can be connected to test points (3) of a printed circuit board (2) to be tested that are located on and/or off grid by means of test pins (31, 32, 33) that are received in guide holes (45-49; 45.1-49.1) in the adapter, wherein the test pins (31, 32, 33) each have a pointed contacting section (a) that is directed towards the respective test point (3) of the printed circuit board (2) and projects from the adapter and an adjacent guidance section (b) that is guided in the associated guide hole (45-49; 45.1-49.1) of the adapter, characterised in that the cross-section of the guidance section (b) decreases conically or in steps towards the contacting section (a), and that the cross-section of the guide holes (45-49; 45.1-49.1) decreases correspondingly.

**2.** An adapter with test pins according to claim 1, characterised in that the cross-section of the test pins (31 to 33) decreases over part of the guidance section (b) or of the shaft length (1) towards the tip (36).

**3.** An adapter with test pins according to claim 1, characterised in that the cross-section of the test pins (31 to 33) decreases over substantially the whole shaft length (1) to the tip (36).

4. An adapter with test pins according to any one of claims 1 to 3, characterised in that the transition from step (39) to step (39) towards the tip (36) is conically tapered.

5. An adapter with test pins according to any one of claims 1 to 4, characterised in that it has a first (15), a second (16), and an intermediate third guide plate (17), said guide plates being arranged parallel to one another and having the guide holes for the test pins (14) therein, wherein the first guide plate (15) has guide holes (45, 45.1) that are on the grid and the second guide plate (16) has guide holes (49, 49.1) that are on and/or off grid.

6. An adapter with test pins according to claim 5, characterised in that the third (17) and any further guide plates (52, 53) arranged between the third (17) and the second guide plates (16) likewise have guide holes (46 to 48 or 46.1 to 48.1) that are on and/or off grid, wherein the guide holes (46.1 to 48.1) of the third and any further guide plates (17, 52, 53) that are off-grid are so placed that on initial insertion vertically into the guide holes (45.1) of the first guide plate the tapering ends of the test pins (32.2) in each case still come within the next guide hole (46.1 to 49.1) and are thus necessarily guided into the off-grid guide holes (49.1) of the second guide plate (16) as they are inserted further.

7. An adapter with test pins according to any one of claims 1 to 6, characterised in that the number of steps (39) is equal to or one less than the number of guide plates (15 to 17).

8. An adapter with test pins according to any one of claims 1 to 7, characterised in that the cross-section of the test pins (31 to 33) tapers progressively, at least near the tip (36). (Fig. 7).

9. An adapter with test pins according to any one of claims 1 to 8, characterised in that at least two, preferably three, further guide plates (17, 52, 53) are arranged between the first and the second guide plate (15, 16).

10. An adapter with test pins according to claim 9, characterised in that the distance (d) between the second guide plate (16) and the neighbouring guide plate (53) is less than the distance (e) between the other guide plates (15, 17, 52).

11. An adapter with test pins according to any one of claims 1 to 10, characterised in that the play ($s_1$ to $s_5$) in the guide holes ( 45 to 49, 45.1 to 49.1) decreases in the direction of insertion (54).

12. An adapter with test pins according to any one of claims 1 to 11, characterised in that the play ($s_5$) in the second guide plate (16) amounts to about 0.1 to 0.2 mm.

13. An adapter with test pins according to any one of claims 1 to 12, characterised in that the tip (36) of the test pins (31 to 33) projects about 0.3 to 1.5 mm, preferably about 0.8 mm, from the second guide plate (16).

14. An adapter with test pins according to any one of claims 1 to 13, characterised in that the second guide plate (16) is thicker than the other guide plates (15, 17, 52, 53).

15. An adapter with test pins according to any one of claims 1 to 14, characterised in that the diameter of the test pins (31 to 33) in the region of the second guide plate (16) amounts to about 0.4 mm.

16. An adapter with test pins according to any one of claims 1 to 15, characterised in that the guide holes (49, 49.1), at least in the second guide plate (16), converge conically or stepwise in the direction of insertion (54).

17. An adapter with test pins according to any one of claims 1 to 16, characterised in that the second guide plate (16) is made up of an outer and an inner plate part (65, 64).

18. An adapter with test pins according to claim 17, characterised in that the section of the guide hole (56) in the inner part of the plate (64) is not displaced as far as the section of the guide hole (55, 66, 67) in the outer part of the plate (65).

19. An adapter with test pins according to any one of claims 1 to 18, characterised in that the play ($s_1$ to $s_5$) is determined by the rims of the holes or steps (57, 58, 60, 61, 62, 63).

20. An adapter with test pins according to any one of claims 1 to 19, characterised in that the guide plates (15 to 17, 52, 53) are spaced apart by spacers, preferably by spacer rails (22, 23) that form a frame.

21. An adapter with test pins according to any one of claims 1 to 20, characterised in that the guide plates (15 to 17, 52, 53) are positioned in the adapter frame (18) by means of at least two transverse grooves (25) made in opposite sides (26) and retaining bolts (24) located therein.

22. An adapter with test pins according to any one of claims 1 to 21, characterised in that the guide holes (45 to 49, 45.1 to 49.1, 55, 56, 57) extend at right angles to the guide plates (15 to 17, 52, 53) or are made (by drilling or stamping) at right angles to the guide plates.

23. An adapter with test pins according to any one of claims 1 to 21, characterised in that the guide holes (45 to 49, 45.1 to 49.1, 55, 56, 57) extend in the guide plates (15 to 17, 52, 53) in the desired inclined position of the associated test pin (14, 32, 32.1, 32.2), or are made (by drilling or stamping) in this inclined position in the guide plates.

**Revendications**

1. Dispositif d'adaptation à pointes de contrôle pour un appareil de contrôle de cartes à circuit imprimé au moyen duquel des contacts de contrôle (7) agencés en réseau sont reliés à des points de contrôle (3) qui sont disposés en réseau et/ou hors réseau d'une carte à circuit imprimé (2) à contrôler par l'intermédiaire de pointes de contrôle (31, 32, 33) engagées dans des trous de guidage (45-49; 45.1-49.1) du dispositif d'adaptation, les pointes de contrôle (31, 32, 33) comportant chacune une partie de contact (a) qui est effilée en direction du point de contrôle (3) de la carte à circuit imprimé (2) et fait saillie par rapport au dispositif d'adaptation ainsi qu'une partie de guidage (b) qui fait suite à la partie de contact et est guidée dans le trou de guidage (45-49; 45.1-49.1) correspondant du dispositif d'adaptation, caractérisé par le fait que la section de la partie de guidage (b) décroît en forme de cône ou en gradins en direction de la partie de contact (a) et que la section des trous de guidage (45-49; 45.1-49.1) diminue en conséquence.

2. Dispositif d'adaptation à pointes de contrôle selon la revendication 1, caractérisé par le fait que la section des pointes de contrôle (31 à 33) décroît en direction de la pointe (36) sur une portion de la partie de guidage (b) ou de la longueur du fût (1).

3. Dispositif d'adaptation à pointes de contrôle selon la revendication 1, caractérisé par le fait que la section des pointes de contrôle (31 à 33) décroît en direction de la pointe (36) sensiblement sur l'ensemble la longueur du fût (1).

4. Dispositif d'adaptation à pointes de contrôle selon l'une des revendications 1 à 3, caractérisé par le fait que le raccordement d'un étage (39) à un autre étage (39) est conique en direction de la pointe (36).

5. Dispositif d'adaptation à pointes de contrôle selon l'une des revendications 1 à 4, caractérisé par le fait qu'il comporte une première (15) et une deuxième (16) plaque de guidage et une troisième plaque de guidage (17) disposée entre celles-ci, lesquelles plaques de guidage sont parallèles entre elles et sont munies des trous de guidage pour les pointes de contrôle (14), la première plaque de guidage (15) portant des trous de guidage (45,45.1) disposés en réseau et la deuxième plaque de guidage (16) portant des trous de guidage (49,49.1) disposés en réseau et/ou hors réseau.

6. Dispositif d'adaptation à pointes de contrôle selon la revendication 5, caractérisé par le fait que la troisième plaque de guidage (17) ou des plaques de guidage (52, 53) supplémentaires montées entre la troisième plaque de guidage (17) et la deuxième plaque de guidage (16) sont également munies de trous de guidage (46 à 48 ou 46.1 à 48.1) disposés en réseau et/ou hors réseau, les trous de guidage (46.1 à 48.1) disposés hors réseau de la troisième ou des plaques de guidage (17, 52, 53) supplémentaires étant agencés de manière telle que les pointes de contrôle (32.2) qui sont engagées d'abord verticalement dans les trous de guidage (45.1) de la première plaque de guidage pénètrent dans tous les cas par leur extrémité effilée dans le trou de guidage voisin (46.1 à 49.1) et soient ainsi déviées dans les trous de guidage (49.1) disposés hors réseau de la deuxième plaque de guidage (16).

7. Dispositif d'adaptation à pointes de contrôle selon l'une des revendications 1 à 6, caractérisé par le fait que le nombre des gradins (39) correspond au nombre des plaques de guidage (15 à 17) ou au nombre des plaques moins une.

8. Dispositif d'adaptation à pointes de contrôle selon l'une des revendications 1 à 7, caractérisé par le fait que la section des pointes de contrôle (31 à 33) décroît de manière progressive jusqu'au voisinage au moins de la pointe (36) (figure 7).

9. Dispositif d'adaptation à pointes de contrôle selon l'une des revendications 1 à 8, caractérisé par le fait qu'au moins deux plaque de guidage supplémentaires, de préférence trois plaques de guidage supplémentaires (17, 52, 53), sont disposées entre la première et la deuxième plaque de guidage (15, 16).

10. Dispositif d'adaptation à pointes de contrôle selon la revendication 9, caractérisé par le fait que la distance (d) entre la deuxième plaque de guidage (16) et la plaque de guidage (53) voisine est inférieure à la distance (e) entre les autres plaques de guidage (15, 17, 52).

11. Dispositif d'adaptation à pointes de contrôle selon l'une des revendications 1 à 10, caractérisé par le fait que le jeu ($s_1$ à $s_5$) des trous de guidage (45 à 49; 45.1 à 49.1) diminue dans la direction de pénétration (54).

12. Dispositif d'adaptation à pointes de contrôle selon l'une des revendications 1 à 11, caractérisé par le fait que le jeu ($s_5$) dans la deuxième plaque de guidage (16) est compris entre 0,1 et 0,2 mm environ.

13. Dispositif d'adaptation à pointes de contrôle selon l'une des revendications 1 à 12, caractérisé par le fait que la pointe (36) des pointes de contrôle (31 à 33) dépasse de 0,3 à 1,5 mm, de préférence de 0,8 mm, par rapport à la deuxième plaque de guidage (16).

14. Dispositif d'adaptation à pointes de contrôle selon l'une des revendications 1 à 13, caractérisé par le fait que la deuxième plaque de guidage (16) a une épaisseur supérieure aux autres plaques de guidage (15,17,52,53).

15. Dispositif d'adaptation à pointes de contrôle selon l'une des revendications 1 à 14, caractérisé par le fait que le diamètre des pointes de contrôle (31 à 33) est de 0,4 mm environ dans la région de la deuxième plaque de guidage (16).

16. Dispositif d'adaptation à pointes de contrôle selon l'une des revendications 1 à 15, caractérisé par le fait que les trous de guidage (49, 49.1) prévus dans la deuxième plaque de guidage (16) au moins sont convergents coniques ou en gradins dans la direction d'engagement (54).

17. Dispositif d'adaptation à pointes de contrôle selon l'une des revendications 1 à 16, caractérisé par le fait que la deuxième plaque de guidage (16) est formée par une partie de plaque extérieure et une partie de plaque intérieure (65,64).

18. Dispositif d'adaptation à pointes de contrôle selon la revendication 17, caractérisé par le fait que le décalage de la portion de trou de guidage (56) située dans la partie de plaque (64) intérieure est moins important que celui de la portion de trou de guidage (55,66,67) située dans la partie de plaque (65) extérieure.

19. Dispositif d'adaptation à pointes de contrôle selon l'une des revendications 1 à 18, caractérisé par le fait que le jeu ($s_1$ à $s_5$) est défini par les bords des trous ou des gradins (57,58,60,61,62,63).

20. Dispositif d'adaptation à pointes de contrôle selon l'une des revendications 1 à 19, caractérisé par le fait que les plaques de guidage (15 à 17, 52, 53) sont maintenues à distance les unes des autres par des éléments d'espacement, de préférence des barrettes d'espacement (22,23) qui forment un cadre.

21. Dispositif d'adaptation à pointes de contrôle selon l'une des revendications 1 à 20, caractérisé par le fait que les plaques de guidage (15 à 17,52,53) sont positionnées dans le cadre du dispositif d'adaptation (18) par au moins deux tiges de fixation (24) logées dans des rainures transversales (25) aménagées dans deux bords (26) opposés.

22. Dispositif d'adaptation à pointes de contrôle selon l'une des revendications 1 à 21, caractérisé par le fait que les trous de guidage (45 à 49; 45.1 à 49.1; 55, 56, 57) sont perpendiculaires aux plaques de guidage (15 à 17, 52, 53) et sont usinés (percés, découpés) perpendiculairement aux plaques de guidage.

23. Dispositif d'adaptation à pointes de contrôle selon l'une des revendications 1 à 21, caractérisé par le fait que les trous de guidage (45 à 49; 45.1 à 49.1; 55, 56, 57) s'étendent avec l'inclinaison souhaitée de la pointe de contrôle (14, 32, 32.1, 32.2) concernée dans les plaques de guidage (15 à 17, 52, 53) et sont usinés (percés, découpés) avec cette inclinaison par rapport aux plaques de guidage.

FIG. 1

# FIG. 2

# FIG. 3

# FIG. 4

# FIG. 5

# FIG. 6

# FIG. 7

FIG. 8

FIG. 9

FIG. 10

FIG. 11

FIG. 12

# FIG. 13    FIG. 14